(19) Europäisches Patentamt
European Patent Office
Office européen des brevets

(11) **EP 1 850 477 A2**

(12) **EUROPEAN PATENT APPLICATION**

(43) Date of publication:
**31.10.2007 Bulletin 2007/44**

(51) Int Cl.:
***H03F 3/45*** $^{(2006.01)}$

(21) Application number: **07106708.6**

(22) Date of filing: **23.04.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK YU**

(30) Priority: **26.04.2006 US 411388**

(71) Applicant: **Qimonda AG**
**81739 München (DE)**

(72) Inventors:
• **Gopalakrishnan, Karthik**
**San Jose, CA 95135 (US)**
• **Partovi, Hamid**
**Sunnyvale, CA 94087 (US)**
• **Ravezzi, Luca**
**Palo Alto, CA 94306 (US)**

(74) Representative: **Banzer, Hans-Jörg**
**Kraus & Weisert**
**Patent- und Rechtsanwälte**
**Thomas-Wimmer-Ring 15**
**80539 München (DE)**

(54) **Operational amplifier**

(57)    An operational amplifier (22) including a first current mirror (32), a second current mirror (34), and a differential pair of transistors (36). The differential pair of transistors (36) are configured to receive two inputs (VIN-, VIN+) to direct current through the first current mirror (32) and the second current mirror (34). The first current mirror (32) provides a first current to a first high impedance node (60) and the second current mirror (34) provides a second current to a second high impedance node (28).

Fig. 2

**Description**

**Background**

Typically, amplifiers are used in electronic circuits to increase the magnitude of a signal, where the amount of signal amplification is called the gain. Amplifiers can be used in any suitable circuit or system, such as a system that includes one or more feedback loops. One type of amplifier is an operational amplifier.

An operational amplifier is a differential amplifier that amplifies the difference between two input signals and provides a single output signal. The operational amplifier includes a positive or non-inverting input terminal and a negative or inverting input terminal. If the positive terminal is more positive than the negative terminal, the output signal is high. If the negative terminal is more positive than the positive terminal, the output signal is low.

Typically, a single stage operational amplifier includes a single high impedance node, such as a high impedance output node. A first order approximation of the gain of the single stage operational amplifier may be given by the transconductance of the differential input transistors times the impedance at the high impedance output node times a possible constant value. A Bode diagram including the magnitude and phase of the single stage operational amplifier's frequency response includes a single significant pole. To achieve higher gain, a two stage operational amplifier can be used.

In a two stage operational amplifier, two high impedance nodes can be used to provide a gain that is much larger than the gain through a single stage operational amplifier. Two low frequency poles associated with the two high impedance nodes are present in the frequency response of the two stage operational amplifier. These two low frequency poles may make the resulting system unstable or nearly unstable. Consequently, the stability margin of the two stage operational amplifier and/or the system that includes the two stage operational amplifier is degraded.

Sometimes, to improve the stability margin of the two stage operational amplifier and/or the system that includes the operational amplifier, a zero is introduced into the frequency response of the two stage operational amplifier. However, usually, the new zero is added at the expense of introducing a third pole at higher frequencies. As a result, the stability margin of the operational amplifier and/or the system that includes the operation amplifier may improve, but typically a large capacitor is needed to maintain the stability margin.

Thus, there is an object of the present invention to overcome the problems mentioned above.

**Summary**

According to the invention, this object is achieved by an operational amplifier as defined in claim 1, 7 or 13, and a method as defined in claim 18 or 23. The dependent claims define preferred and advantageous embodiments of the present invention.

One aspect of the present invention provides an operational amplifier including a first current mirror, a second current mirror, and a differential pair of transistors. The differential pair of transistors are configured to receive two inputs to direct current through the first current mirror and the second current mirror. The first current mirror provides a first current to a first high impedance node and the second current mirror provides a second current to a second high impedance node.

**Brief Description of the Drawings**

The accompanying drawings are included to provide a further understanding of the present invention. The drawings illustrate the embodiments of the present invention and together with the description serve to explain the principles of the invention. The elements of the drawings are not necessarily to scale relative to each other. Like reference numerals designate corresponding similar parts.

Figure 1 is a diagram illustrating one embodiment of an electronic system that includes one embodiment of an operational amplifier, according to the present invention.

Figure 2 is a diagram illustrating one embodiment of an operational amplifier of the present invention.

Figure 3 is a bode diagram illustrating the overall gain magnitude versus frequency and the overall gain phase versus frequency of one embodiment of an operational amplifier of the present invention.

**Detailed Description**

In the following Detailed Description, reference is made to the accompanying drawings, which form a part hereof, and in which is shown by way of illustration specific embodiments in which the invention may be practiced. In this regard, directional terminology, such as "top," "bottom," "front," "back," "leading," "trailing," etc., is used with reference to the orientation of the Figure(s) being described. Because components of embodiments of the present invention can be positioned in a number of different orientations, the directional terminology is used for purposes of illustration and is in no way limiting. It is to be understood that other embodiments may be utilized and structural or logical changes may be made without departing from the scope of the present invention. The following detailed description, therefore, is not to be taken in a limiting sense, and the scope of the present invention is defined by the appended claims.

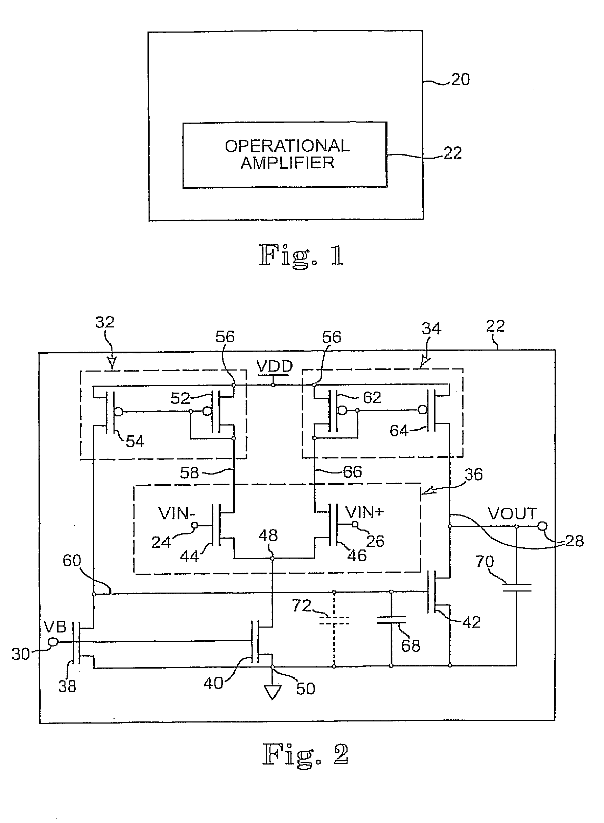

Figure 1 is a diagram illustrating one embodiment of an electronic system 20 that includes one embodiment of an operational amplifier 22, according to the present invention. Operational amplifier 22 is a two stage operational amplifier that includes a first gain path configured to provide a low gain and large frequency bandwidth and a second gain path configured to provide a high gain and small frequency bandwidth. The overall gain frequency response includes a first pole, a second pole at a higher frequency than the first pole, and a zero. Operational amplifier 22 is configured to introduce the zero into its frequency response, without introducing a third pole. As a result, the stability margin of operational amplifier 22 and/or electronic system 20 is improved and the stability margin improvement is achieved without the use of a large compensation capacitor.

In one embodiment, electronic system 20 includes a feedback loop and operational amplifier 22 is part of the feedback loop such that the zero is used to cancel the first non-dominant pole of the feedback loop system. As a result, the feedback open loop phase margin is increased and the stability margin of electronic system 20 is improved.

In one embodiment, electronic system 20 is an advanced memory buffer (AMB) circuit. In other embodiments, electronic system 20 can be any suitable system that includes an operational amplifier, such as operational amplifier 22.

Operation amplifier 22 is a two stage operational amplifier that provides an improved stability margin and a gain that can be much higher than the gain of a single stage operational amplifier. In one embodiment, operational amplifier 22 includes a differential pair of transistors configured to receive differential inputs. The differential pair of transistors direct current through a first current mirror and a second current mirror based on the received differential input signals. The first current mirror provides a first current to one high impedance node and the second current mirror provides a second current to the other high impedance node.

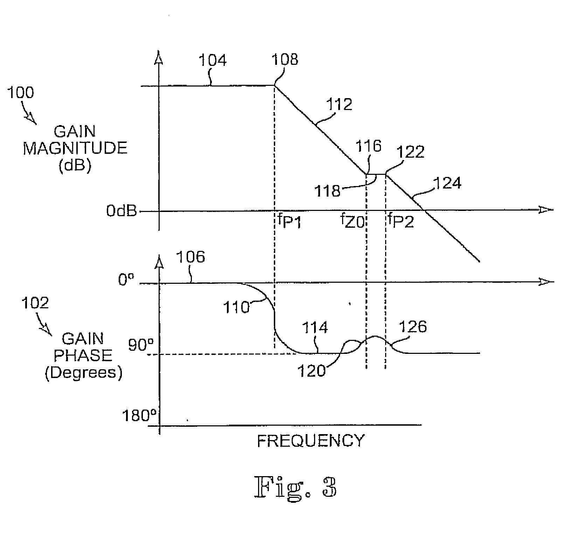

Figure 2 is a diagram illustrating one embodiment of operational amplifier 22. To include operational amplifier 22 in a system, such as electronic system 20, the system is electrically coupled to inverting or negative input 24, non-inverting or positive input 26, and/or output 28. Operational amplifier 22 is biased via bias voltage signal VB at bias voltage input 30 and receives negative input signal VIN- at 24 and positive input signal VIN+ at 26. Operational amplifier 22 provides output signal VOUT at 28. The gain frequency response of operational amplifier 22 includes a zero, without introducing a third pole, and the stability margin of operational amplifier 22 and/or the system that includes operation amplifier 22 is improved without the use of a large compensation capacitor.

Operational amplifier 22 includes a first current mirror 32, a second current mirror 34, a differential pair of input transistors 36, a transistor 38, a bias transistor 40, and an output transistor 42. Each of the transistors of transistor 38, bias transistor 40, and output transistor 42, is an n-channel metal oxide semiconductor (NMOS) transistor. The differential pair of input transistors 36 includes a first input transistor 44 and a second input transistor 46. Each of the transistors of first input transistor 44 and second input transistor 46 is an NMOS transistor.

The gate of first input transistor 44 is electrically coupled to negative input 24. The gate of second input transistor 46 is electrically coupled to positive input 26. One side of the drain-source path of first input transistor 44 is electrically coupled to one side of the drain-source path of second input transistor 46 and one side of the drain-source path of bias transistor 40 at 48. The other side of the drain-source path of bias transistor 40 is electrically coupled to a reference, such as ground, at 50. The gate of bias transistor 40 is electrically couple to bias voltage input 30 to receive bias voltage VB at 30.

First current mirror 32 includes a first current mirror transistor 52 and a second current mirror transistor 54. Each of the transistors of first current mirror transistor 52 and second current mirror transistor 54 is a p-channel metal oxide semiconductor (PMOS) transistor. One side of the drain-source path of first current mirror transistor 52 is electrically coupled to power VDD at 56. The other side of the drain-source path of first current mirror transistor 52 is electrically coupled at 58 to the other side of the drain-source path of first input transistor 44, the gate of first current mirror transistor 52, and the gate of second current mirror transistor 54. One side of the drain-source path of second current mirror transistor 54 is electrically coupled to power VDD at 56. The other side of the drain-source path of second current mirror transistor 54 is electrically coupled at 60 to one side of the drain-source path of transistor 38 and the gate of output transistor 42. The other side of the drain-source path of transistor 38 is electrically coupled to the reference at 50. The gate of transistor 38 is electrically couple to bias voltage input 30 to receive bias voltage VB at 30.

Second current mirror 34 includes a third current mirror transistor 62 and a fourth current mirror transistor 64. Each of the transistors of third current mirror transistor 62 and fourth current mirror transistor 64 is a PMOS transistor. One side of the drain-source path of third current mirror transistor 62 is electrically coupled to power VDD at 56. The other side of the drain-source path of third current mirror transistor 62 is electrically coupled at 66 to the other side of the drain-source path of second input transistor 46, the gate of third current mirror transistor 62, and the gate of fourth current mirror transistor 64. One side of the drain-source path of fourth current mirror transistor 64 is electrically coupled to power VDD at 56. The other side of the drain-source path of fourth current mirror transistor 64 is electrically coupled at 28 to one side of the drain-source path of output transistor 42. The other side of the drain-source path of output transistor 42 is electrically coupled to the reference at 50.

In one embodiment, the input to output ratio of each of the two current mirrors 32 and 34 is 1. In other embodiments, the input to output ratio of first current mirror 32 is any suitable value and the input to output ratio of second current mirror 34 is any suitable value.

Operational amplifier 22 includes a first capacitor 68, a second capacitor 70, and a parasitic capacitor 72, indicated in dashed lines. One side of first capacitor 68 and one side of parasitic capacitor 72 are electrically coupled at 60 to the gate of output transistor 42. The other side of first capacitor 68 and the other side of parasitic capacitor 72 are electrically coupled to the reference at 50. Also, one side of second capacitor 70 is electrically coupled at 28 to one side of the drain-source path of output transistor 42, and the other side of second capacitor 70 is electrically coupled to the reference at 50.

In operation, bias transistor 40 receives bias voltage VB at 30 and provides bias to the differential pair of input transistors 36. Also, transistor 38 receives bias voltage VB at 30 and provides a first high impedance node at 60. The gate of output transistor 42 receives a signal via the first high impedance node at 60 to control output transistor 42. Output 28 provides a second high impedance node at 28. In one embodiment, transistor 38 is smaller than bias transistor 40.

First input transistor 44 receives negative input signal VIN- at 24 and second input transistor 46 receives positive input signal VIN+ at 26. If negative input signal VIN- at 24 is greater or more positive than positive input signal VIN+ at 26, the current through first input transistor 44 is larger than the current through second input transistor 46. Thus, the differential input transistors 36 steer more current through first current mirror 32 and first current mirror transistor 52 than through second current mirror 34 and third current mirror transistor 62, which reduces the current flowing through fourth current mirror transistor 64. The current through first current mirror transistor 52 is mirrored through second current mirror transistor 54 and first high impedance node 60 is charged to a higher voltage level that makes output transistor 42 more conductive. The increase in the current drained by output transistor 42 and the reduction in the current provided by fourth current mirror transistor 64 discharges second high impedance node 28 and reduces the voltage level in output signal VOUT at 28. Thus, if negative input signal VIN- at 24 is greater than positive input signal VIN+ at 26, output signal VOUT is low.

If positive input signal VIN+ at 26 is greater or more positive than negative input signal VIN- at 24, second input transistor 46 is more conductive than first input transistor 44. Thus, the differential input transistors 36 steer more current through second current mirror 34 and third current mirror transistor 62 than through first current mirror 32 and first current mirror transistor 52, which reduces the current flowing through second current mirror transistor 54. Transistor 38 discharges the first high impedance node 60 to a lower voltage level, which makes output transistor 42 less conductive and reduces the drain current through output transistor 42. The current through third current mirror transistor 62 is mirrored through fourth current mirror transistor 64 and the reduced drain current through output transistor 42 in combination with the increased current through fourth current mirror transistor 64 charges second high impedance node 28 to a higher voltage level and provides the higher voltage level in output signal VOUT at 28. Thus, if positive input signal VIN+ at 26 is greater or more positive than negative input signal VIN- at 24, output signal VOUT is higher.

Operational amplifier 22 is a two stage operational amplifier that includes a first gain path and a second gain path. The first gain path is a low gain and large bandwidth path. The second gain path is a high gain and low or small bandwidth path.

In the following Equations it is assumed that the input to output ratio of each of the two current mirrors 32 and 34 is 1. In other embodiments, the input to output ratio of first current mirror 32 can be any suitable value and the input to output ratio of second current mirror 34 can be any suitable value.

The overall gain of operational amplifier 22 is given by Equation I.

Equation I

$$A = \left( gm_{36} * \frac{Rout_{28}}{1 + j\omega C_{70} Rout_{28}} \right) * \left( gm_{42} * \frac{Rout_{60}}{1 + j\omega Rout_{60}(C_{68} + C_{72})} + 1 \right)$$

Where gm36 is the transconductance of first and second input transistors 44 and 46, ROUT60 is the equivalent resistance at first high impedance node 60, C68 is the capacitance of first capacitor 68, C72 is the capacitance of parasitic capacitor 72 connected to first high impedance node 60, gm42 is the transconductance of output transistor 42, C70 is the capacitance of second capacitor 70, and ROUT28 is the equivalent resistance at second high impedance node 28.

The overall gain of operational amplifier 22, given by Equation I, includes the first gain path's low gain and large bandwidth term, given by Equation II, and the second gain path's high gain and small bandwidth term, given by Equation III.

Equation II

$$A_{LG,LB} = gm_{36} * \frac{Rout_{28}}{1 + j\omega C_{70} Rout_{28}}$$

Equation III

$$A_{HG,SB} = gm_{36} * \frac{Rout_{28}}{1 + j\omega C_{70} Rout_{28}} * gm_{42} * \frac{Rout_{60}}{1 + j\omega Rout_{60}(C_{68} + C_{72})}$$

The overall gain of operational amplifier 22 includes a first pole fP1, given by Equation IV, and a second pole fP2, given by Equation V. A third pole due to parasitic capacitor 72 is avoided because the capacitance C72 of parasitic capacitor 72 adds up directly to the capacitance C68 of first capacitor 68.

Equation IV

$$f_{P1} = \frac{1}{2\pi Rout_{60}(C_{68} + C_{72})}$$

Equation V

$$f_{P2} = \frac{1}{2\pi Rout_{28} C_{70}}$$

Also, the overall gain of operational amplifier 22 includes a zero fZ0, given by Equation VI, where the approximated expression of fZ0 is valid if the product of ROUT60 and gm42 is greater than one.

Equation VI

$$f_{Z0} = \frac{1 + gm_{42} Rout_{60}}{2\pi Rout_{60}(C_{68} + C_{72})} \approx \frac{gm_{42}}{2\pi (C_{68} + C_{72})}$$

Operational amplifier 22 is a two stage operational amplifier that includes a first gain path that provides a low gain and large frequency bandwidth and a second gain path that provides a high gain and small frequency bandwidth. The overall gain frequency response includes a first pole at frequency fP1, a second pole at frequency fP2, and a zero at frequency fZ0, without introducing a third pole.

To improve the stability margin of operational amplifier 22 and/or the system, such as electronic system 20, that includes operational amplifier 22, the values of gm42 and capacitance C68 are picked to position zero fZ0 substantially next to or close to the first non-dominant pole. The first non-dominant pole is a pole, such as second pole fP2 or another pole in the system that includes operational amplifier 22. As a result, the stability margin of operational amplifier 22 and/or the system that includes operational amplifier 22 is improved and the stability margin improvement is achieved without the use of a large compensation capacitor.

Figure 3 is a bode diagram illustrating the overall gain magnitude versus frequency at 100 and the overall gain phase versus frequency at 102 of one embodiment of operational amplifier 22. At lower frequencies, the overall gain magnitude at 100 is at a maximum value at 104 and the overall gain phase is at 0 degrees at 106. At frequencies near the first pole fP1 at 108, the overall gain phase at 102 transitions toward 90 degrees at 110. At frequencies beyond the first pole fP1 at 108, the overall gain magnitude at 100 decreases at 112 and the overall gain phase at 102 transitions to 90 degrees at 114.

At frequencies near the zero fZ0 at 116, the overall gain phase at 102 increases at 120. At the zero fZ0 at 116, the overall gain magnitude at 100 stops decreasing to provide the flat overall gain at 118. At frequencies beyond the second pole fP2 at 122, the overall gain magnitude at 100 decreases at 124. By placing the zero fZ0 at 116 substantially next to or close to the second pole fP2 at 122, the overall gain phase at 102 returns to a 90 degree phase at 126. The zero fZ0 at 116 is positioned substantially next to the second pole fP2 at 122 and the overall gain phase at 102 remains substantially at 90 degrees at frequencies beyond the first pole fP1 to stabilize operational amplifier 22.

In other embodiments, the zero fZ0 at 116 can be situated substantially at the second pole fP2 at 122 or at a higher frequency than second pole fP2 at 122, but substantially next to the second pole fP2 at 122 to provide a sufficient phase margin for the overall loop gain. In other embodiments, the zero fZ0 at 116 can be positioned substantially next to the first non-dominant pole of a system that includes operational amplifier 22 to improve the stability of the system.

Operational amplifier 22 is a two stage operational amplifier that provides a gain magnitude, which can be much larger than the gain magnitude of a single stage operational amplifier. Operational amplifier 22 provides an overall gain response that includes a first pole fP1, a second pole fP2 at a higher frequency than the first pole fP1, and a zero fZ0 . In one embodiment, the zero fZ0 is positioned substantially next to the second pole fP2 and the overall gain phase remains substantially at 90 degrees at frequencies beyond the first pole fP1. As a result, the stability margin of operational amplifier 22 is improved.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

**Claims**

1. An operational amplifier comprising:

   a first current mirror (32);
   a second current mirror (34); and
   a differential pair of transistors (36) configured to receive two inputs (VIN-, VIN+) to direct current through the first current mirror (32) and the second current mirror (34), wherein the first current mirror (32) provides a first current to a first high impedance node (60) and the second current mirror (34) provides a second current to a second high impedance node (28).

2. The operational amplifier of claim 1, comprising:

   a capacitor (68) situated at the first high impedance node (60) and configured to add directly to a parasitic capacitance (72) at the first high impedance node (60).

3. The operational amplifier of claim 1 or 2, comprising:

   a transistor (42) configured to receive a control signal via the first high impedance node (60) and provide an output signal (VOUT) at the second high impedance node (28).

4. The operational amplifier according to any one of claims 1-3, comprising:

   a first gain path that provides a high gain and small frequency bandwidth; and
   a second gain path that provides a low gain and large frequency bandwidth.

5. The operational amplifier according to any one of claims 1-4, wherein an overall gain response consists of a first pole (fP1), a second pole (fP2) at a higher frequency than the first pole (fP1), and a zero (fZ0).

6. The operational amplifier of claim 5, wherein the zero (fZ0) is situated substantially next to the second pole (fP2).

**7.** An operational amplifier comprising:

a first gain path configured to provide a low gain and large frequency bandwidth; and
a second gain path configured to provide a high gain and small frequency bandwidth, wherein an overall gain response consists of a first pole (fP1), a second pole (fP2) at a higher frequency than the first pole, and a zero (fZ0).

**8.** The operational amplifier of claim 7, wherein the overall gain response includes a gain phase of substantially 90 degrees at frequencies above the first pole (fP1).

**9.** The operational amplifier of claim 7 or 8, wherein the zero (fZ0) is situated substantially close to a first non-dominant pole in a feedback loop that includes the operational amplifier (22) to improve the stability margin of the feedback loop.

**10.** The operational amplifier according to any one of claims 7-9, comprising:

a first high impedance node (60) having a parasitic capacitance (72); and
a first capacitor (68) situated at the first high impedance node (60), wherein the first capacitor (68) is configured to add directly to the parasitic capacitance (72) at the first high impedance node (60).

**11.** The operational amplifier of claim 10, comprising:

a second high impedance node (28); and
a second capacitor (70) situated at the second high impedance node (28).

**12.** The operational amplifier of claim 11, comprising:

a first current mirror (32); and
a second current mirror (34), wherein the first current mirror (32) is configured to provide a first current to the first high impedance node (60) and the second current mirror (34) is configured to provide a second current to the second high impedance node (28).

**13.** An operational amplifier comprising:

means (36) for directing current to a first path and to a second path based on differential input signals (VIN-, VIN+);
means (32) for providing a first current to a first high impedance node (60) based on the directed current in the first path; and
means (34) for providing a second current to a second high impedance node (28) based on the directed current in the second path.

**14.** The operational amplifier of claim 13, comprising:

means for adding a capacitance (68) directly to a parasitic capacitance (72) at the first high impedance node (60).

**15.** The operational amplifier of claim 13 or 14, comprising:

means (42) for providing an amplifier stage that receives a control signal via the first high impedance node (60) to provide an output signal (VOUT) via the second high impedance node (28).

**16.** The operational amplifier according to any one of claims 13-15, comprising:

means for providing a first gain path that includes a high gain and a small frequency bandwidth; and
means for providing a second gain path that includes a low gain and a large frequency bandwidth.

**17.** The operational amplifier according to any one of claims 13-16, comprising:

means for providing an overall gain response that consists of a first pole (fP1), a second pole (fP2) at a higher frequency than the first pole (fP1), and a zero (fZ0).

**18.** A method for amplifying signals, comprising:

directing current to flow through a first current mirror (32) based on the signals (VIN-, VIN+);
directing current to flow through a second current mirror (34) based on the signals (VIN-, VIN+);
providing a first current to a first high impedance node (60) via the first current mirror (32); and
providing a second current to a second high impedance node (28) via the second current mirror (34).

19. The method of claim 18, comprising:

   adding a capacitance (68) directly to a parasitic capacitance (72) at the first high impedance node (60).

20. The method of claim 18 or 19, comprising:

   controlling a transistor (42) based on a control signal received via the first high impedance node (60); and
   providing an output signal (VOUT) at the second high impedance node (28) based on the controlled transistor (42).

21. The method according to any one of claims 18-20, comprising:

   amplifying the signals (VIN-, VIN+) via a high gain and small frequency bandwidth path; and
   amplifying the signals (VIN-, VIN+) via a low gain and large frequency bandwidth path.

22. The method according to any one claims 18-21, comprising:

   providing an overall gain response that consists of a first pole (fP1), a second pole (fP2) at a higher frequency than the first pole (fP1), and a zero (fZ0).

23. A method for amplifying signals, comprising:

   amplifying the signals (VIN-, VIN+) via a high gain and small frequency bandwidth path;
   amplifying the signals (VIN-, VIN+) via a low gain and large frequency bandwidth path; and
   providing an overall gain response that consists of a first pole (fP1) a second pole (fP2) at a higher frequency than the first pole (fP1), and a zero (fZ0).

24. The method of claim 23, wherein providing the overall gain response comprises:

   providing a gain phase of substantially 90 degrees at frequencies above the first pole (fP1).

25. The method of claim 23 or 24, wherein providing the overall gain response comprises:

   providing the zero (fZ0) substantially close to a first non-dominant pole in a feedback loop that includes the operational amplifier (22) to improve the stability margin of the feedback loop.

26. The method according to any one of claims 23-25, comprising:

   adding a first capacitance (68) directly to a parasitic capacitance (72) at a first high impedance node (60).

27. The method of claim 26, comprising:

   providing a second capacitance (70) at a second high impedance node (28).

28. The operational amplifier according to any one of claims 1-17, configured to implement the method according to any one of claims 18-27.

Fig. 1

Fig. 2

Fig. 3